# EUROPEAN PATENT SPECIFICATION

(11) **EP 0 520 319 B1**
(45) Date of publication and mention of the grant of the patent: **09.08.1995**
(21) Application number: 92110253.9
(22) Date of filing: 17.06.1992
(51) Int. Cl.: G03B 27/04, G03B 27/20

(54) **Apparatus for making contact prints**
Apparat zur Herstellung von Kontaktkopien
Appareil pour la fabrication de copies par contact

(30) Priority: 24.06.1991 GB 9113562
(43) Date of publication of application: 30.12.1992
(73) Proprietor: DAINIPPON SCREEN ENGINEERING OF EUROPE Co. LIMITED, Tongwell, Milton Keynes MK15 8HT (GB)
(72) Inventor: Dunn, Philip, Willen Milton Keynes MK15 9 HP (GB); Leete, Andrew, Milton Keynes (GB); Phipps, John, St. Stephens St. Albans AL3 4NJ (GB); Reid, Geoffrey, St. Albans AL1 5EN (GB); Smith, Michael, Stotfold Hitchin, Herts. (GB)
(74) Representative: Meddle, Alan Leonard

(56) References cited:
- DE-B- 2 549 989
- US-A- 3 409 367
- US-A- 4 437 759
- US-A- 4 755 854

## Description

This invention relates to an apparatus for making contact prints, and more particularly to an apparatus for making prints by placing a sensitive sheet in contact with an original, e.g. a photographic negative or positive, and exposing the same to light through the original. Such an apparatus will hereinafter be referred to simply as a "contact printer".

A known contact printer, see for example DE-B-25 49 989, comprises a free-standing printing cabinet made of an opaque material such as steel. The top of the printing cabinet is closed by a transparent printing plate made, for example, of glass. An ultra-violet light source is mounted within the printing cabinet in a light-tight enclosure spaced beneath the printing plate.

The enclosure for the light source is provided with a shutter mechanism which can be opened to illuminate a photographic negative or positive and sensitive sheet placed on the printing plate after an opaque rubber blind has been drawn over the printing plate by a cover mechanism and a vacuum has been applied to draw the blind against the printing plate to ensure intimate contact between the sensitive sheet and the negative.

In the known contact printer, one end of the flexible blind is fixed to the printer cabinet adjacent to one edge of the printing plate and the other end of the blind is attached to a reel carried by a movable cover head. The blind is unwound from the reel as the cover head is moved from a parked position, adjacent to the one edge of the printing plate, to an exposure position adjacent the opposite edge of the printing plate. The cover head is driven between its two end positions along a linear path by a linear drive mechanism and stands on the same level as the printing plate when in its end positions.

In practice, the one edge of the printing plate is at the front of the contact printer and it has been found that, when in its parked position, the cover head obstructs a human operator's access to the printer because the cover head projects well above the surface of the printing plate when the head is in its parked position.

It is an object of the present invention to provide a contact printer having an improved cover mechanism which facilitates access to the contact printer by an operator.

Accordingly, the present invention provides a contact printer comprising a printing cabinet housing an exposing source and including a transparent printing plate through which a sensitive sheet placed on the printing plate in contact with an original is exposed by the source to make a print, and cover means for drawing an opaque blind over the printing plate prior to exposure of a sensitive sheet placed thereon, one end of the blind being attached to the printing cabinet adjacent one edge of the printing plate and the cover means comprising a movable cover head carrying a reel from which the blind is unwound as the cover head is moved from a parked position adjacent the one edge of the printing plate to an exposure position adjacent the opposite edge of the printing plate, in which contact printer the cover head in its parked position lies on a downwardly inclined portion of the printing cabinet adjacent the one edge of the printing plate, thereby facilitating access to the surface of the printing plate from the one edge thereof.

Conveniently, the printing head is moved between the parked position and the exposure position by a carriage block which is driven along a linear guide and to which the cover head is pivotally attached so as to be able to adopt an inclined orientation relative to the linear guide of the carriage block in the parked position.

Suitably, the carriage block is driven along the linear guide by an endless belt to which the carriage block is clamped.

The endless belt is preferably a toothed drive belt running around a fixed drive pulley and an adjustable tensioning pulley.

Desirably, the cover head is provided with a roller bearing running on a guide rail which has a straight main portion extending parallel to the linear guide and a ramped end portion for directing the head into the inclined parked position.

In order that the invention may be more readily understood, an embodiment will thereof will now be described, by way of example, with reference to the accompanying drawings, in which:
Figure 1 is a diagrammatic side view of a contact printer embodying the invention; and

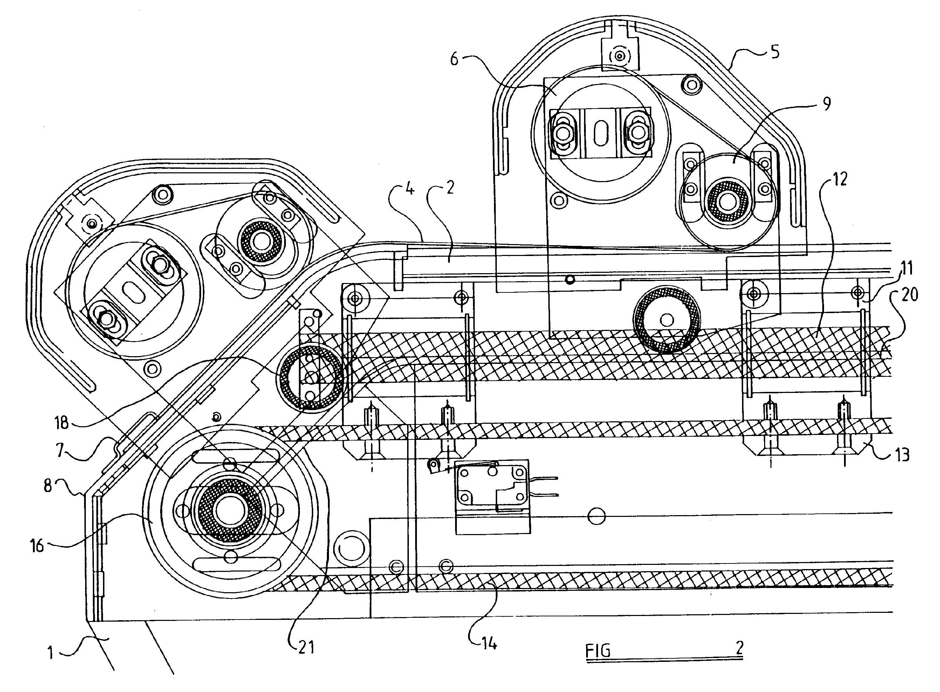

Figure 2 is a detailed side view of a portion of a cover mechanism of the contact printer of Figure 1.

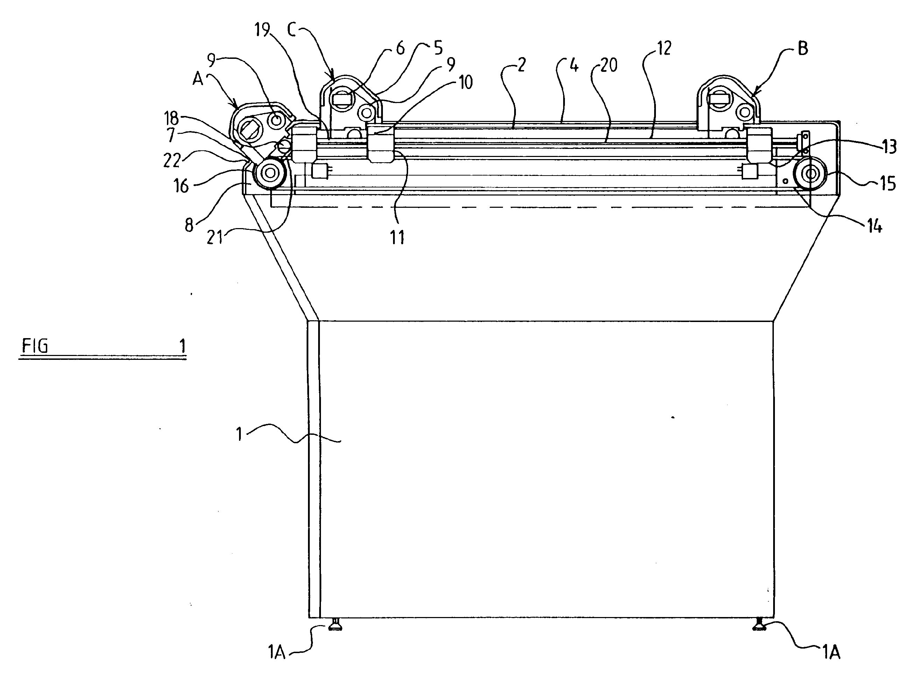

Referring firstly to Figure 1, a contact printer embodying the present invention comprises a free-standing printing cabinet 1 having feet 1A and made of an opaque material, such as steel. The printing cabinet 1 is closed by a transparent glass printing plate 2 forming part of a top wall of the cabinet.

An ultra-violet light source (not shown) for exposing a sensitive photographic sheet (not shown) placed on the printing plate in contact with an original in the form of a photographic negative is accommodated within the printing cabinet 1 spaced beneath the printing plate 2. The light source is contained within a light-tight casing provided with a normally closed shutter mechanism (not shown) which is opened in order to illuminate the sensitive sheet through the printing plate 2 after a flexible rubber blind 4 has been drawn over the printing plate 2 by a cover mechanism and a vacuum has been applied to the space between the plate 2 and blind 4 by vacuum means (not shown) to ensure intimate contact between the sensitive sheet and the original placed on the printing plate 2.

The cover mechanism for extending the opaque blind 4 over the printing plate 2 comprises a movable cover head 5 containing a spring-loaded reel 6. One end 7 of the blind 4 is secured along a front edge 8 of the casing 1 adjacent a front edge of the printing plate 2. The other end of the blind 4 is guided around a guide roller 9 in the cover head 5 and is attached to the reel 6.

The cover head 5 is pivotally attached by means of pivotal connections 10 to a carriage block 11 which is driven along a linear guide 12 in the form of a hardened ground shaft extending from the front to the rear of the printing cabinet 1 on each side thereof. The carriage block 11 is attached by clamping plate 13 to an endless toothed drive belt 14 which is driven by a fixed motor-driven drive pulley 15 and is tensioned by a second pulley 16 which is adjustable to vary the distance between the pulleys 15 and 16.

The cover head 5 comprises a roller bearing 18 which runs on a guide rail 19 extending along each side of the printing cabinet 1. The guide rail 19 has a main straight portion 20 extending parallel to the linear guide 12 and a downwardly inclined ramp portion 21 at its front end.

The cover head 5 is movable between a parked position A and an exposure position B by rotation of the drive pulley 15 in the appropriate direction. C indicates an intermediate position of the cover head 5 during its travel between the two end positions A & B.

In the parked position A of the cover head 5, the head is pivoted about the pivotal connection 10 with the carriage block 11 so as to adopt an inclined orientation lying along an inclined front edge portion 22 of the printing cabinet 1 at an angle to the linear guide 12. This out-of-the-way position facilitates a human operator's access to the printing plate 2.

The features disclosed in the foregoing description, in the following claims and/or in the accompanying drawings may, both separately and in any combination thereof, be material for realising the invention in diverse forms thereof.

## Claims

1. A contact printer comprising a printing cabinet (1) housing an exposing source and including a transparent printing plate (2) through which a sensitive sheet placed on the printing plate in contact with an original is exposed by the source to make a print, and cover means (4,5,6) for drawing an opaque blind (4) over the printing plate prior to exposure of a sensitive sheet placed thereon, one end (7) of the blind (4) being attached to the printing cabinet (11) adjacent one edge of the printing plate (2) and the cover means (4,5,6) comprising a movable cover head (5) carrying a reel (6) from which the blind (4) is unwound as the cover head (5) is moved from a parked position (A) adjacent the one edge (7) of the printing plate (2) to an exposure position (B) adjacent the opposite edge of the printing plate, characterised in that the cover head (5) in its parked position (A) lies on a downwardly inclined portion (22) of the printing cabinet (1) adjacent the one edge (7) of the printing plate (2), thereby facilitating access to the surface of the printing plate (2) from the one edge (7) thereof.

2. A contact printer according to claim 1, wherein the cover head (5) is moved between the parked position (A) and the exposure position (B) by a carriage block (11) which is driven along a linear guide (12) and to which the cover head (5) is pivotally attached so as to be able to adopt an inclined orientation relative to the linear guide (12) of the carriage block (11) when the cover head (5) is in its parked position (A).

3. A contact printer according to claim 2, wherein the carriage block (11) is driven along the linear guide (12) by an endless belt (14) to which the carriage block (11) is attached.

4. A contact printer according to claim 3, wherein the endless belt (14) is a toothed drive belt running around a fixed drive pulley (15) and an adjustable tensioning pulley (16).

5. A contact printer according to any one of claims 2 to 4, wherein the cover head (5) is provided with a roller bearing (18) running on a guide rail (19) which has a straight main portion (20) extending parallel to the linear guide (12) and a ramped end portion (21) for directing the cover head (5) into the inclined parked position A.

6. A contact printer according to any preceding claim, wherein the exposing source is an ultra-violet light source.

## Patentansprüche

1. Kontaktkopierer umfassend ein Kopierergehäuse (1), das eine Beleuchtungsquelle beherbergt und eine transparente Kopiererplatte (2) enthält, durch welche eine lichtempfindliche Schicht, die auf der Kopiererplatte in Kontakt mit einem Original angeordnet ist, von der Quelle zum Herstellen einer Kopie bestrahlt wird, und Abdeckmittel (4, 5, 6) zum Ziehen einer opaken Abdeckung (4) über die Kopiererplatte vor dem Bestrahlen einer darauf angeordneten, lichtempfindlichen Schicht, wobei ein Ende (7) der Abdeckung (4) an dem Kopierergehäuse (1), benachbart einer Kante der Kopiererplatte (2), angebracht ist und die Abdeckmittel (4, 5, 6) einen bewegbaren Abdeckkopf (5) umfassen, der eine Rolle (6) trägt, von welcher die Abdeckung (4) abgewickelt wird, wenn der Abdeckkopf (5) von einer Parkposition (A), benachbart der einen Kante (7) der Kopiererplatte (2), zu einer Beleuchtungsposition (B), benachbart der gegenüberliegenden Kante der Kopiererplatte, bewegt wird, dadurch gekennzeichnet, daß der Abdeckkopf (5) in seiner Parkposition (A) auf einem nach unten geneigten Bereich (22) des Kopierergehäuses (1), benachbart zu der einen Kante (7) der Kopiererplatte (2), liegt, wodurch der Zugang zu der Oberfläche der Kopiererplatte (2) von der einen Kante (7) derselben erleichtert wird.

2. Kontaktkopierer nach Anspruch 1, dadurch gekennzeichnet, daß der Abdeckkopf (5) zwischen der Parkposition (A) und der Beleuchtungsposition (B) durch einen Schlittenblock (11) bewegt wird, der entlang einer linearen Führung (12) angetrieben wird und an welchen der Abdeckkopf (5) drehbar angebracht ist, so daß es ihm möglich ist, eine geneigte Orientierung relativ zu der linearen Führung (12) des Schlittenblocks (11) einzunehmen, wenn der Abdeckkopf (5) sich in seiner Parkposition (A) befindet.

3. Kontaktkopierer nach Anspruch 2, dadurch gekennzeichnet, daß der Schlittenblock (11) entlang der linearen Führung (12) angetrieben wird durch ein Endlosband (14), an welches der Schlittenblock (11) angebracht ist.

4. Kontaktkopierer nach Anspruch 3, dadurch gekennzeichnet, daß das Endlosband (4) ein zahnradgetriebenes Band ist, das um eine feststehende Antriebsrolle (15) und eine einstellbare Spannungsrolle (16) herumläuft.

5. Kontaktkopierer nach irgendeinem der Ansprüche 2 bis 4, dadurch gekennzeichnet, daß der Abdeckkopf (5) mit einem Rollager (18) ausgerüstet ist, das auf einer Führungsschiene (19) läuft, die einen gerade verlaufenden Hauptbereich (20), der sich parallel zu der linearen Führung (12) erstreckt, und einen rampenartigen Endbereich (21) zum Führen des Abdeckkopfes (5) in die geneigte Parkposition (A) aufweist.

6. Kontaktkopierer nach irgendeinem der vorangegangenen Ansprüche, dadurch gekennzeichnet, daß die Beleuchtungsquelle eine ultraviolette Lichtquelle ist.

## Revendications

1. Un copieur à contact comprenant un coffret d'impression (1) renfermant une source d'excitation et incluant une plaque d'impression transparente (2) à travers laquelle une feuille sensible placée sur la plaque d'impression en contact avec un original est exposée par la source pour obtenir une copie, et un moyen de couvercle (4, 5, 6) pour tirer un masque opaque (4) sur la plaque d'impression avant l'exposition d'une feuille sensible placée sur celle-ci, une extrémité (7) du masque (4) étant liée au coffret d'impression (11) adjacent à un côté de la plaque d'impression (2) et le moyen de couvercle (4, 5, 6) comprenant une tête de couvercle mobile (5) supportant une bobine (6) depuis laquelle le masque (4) est déroulé lorsque la tête de couvercle (5) est déplacée depuis une position de stationnement (A) adjacente audit un côté (7) de la plaque d'impression (2) vers une position d'exposition (B) adjacente au côté opposé de la plaque d'impression, caractérisé en ce que la tête de couvercle (5) dans sa position de stationnement (A) est sur une portion inclinée vers le bas (22) du coffret d'impression (1) adjacente audit un côté (7) de la plaque d'impression (2), de manière à faciliter l'accès à la surface de la plaque d'impression (2) depuis ledit un côté (7) de celle-ci.

2. Un copieur à contact conforme à la revendication 1, dans lequel la tête de couvercle (5) est déplacée entre la position de stationnement (A) et la position d'exposition (B) par un bloc de chariot (11) qui est entraîné le long d'un guide linéaire (12) et auquel la tête de couvercle (5) est liée à pivotement de manière à être capable d'adopter une orientation inclinée par rapport au guide linéaire (12) du bloc de chariot (11) lorsque la tête de couvercle (5) est dans sa position de stationnement (A).

3. Un copieur à contact conforme à la revendication 2, dans lequel le bloc de chariot (11) est entraîné le long du guide linéaire (12) par une courroie sans fin (14) à laquelle le bloc de chariot (11) est lié.

4. Un copieur à contact conforme à la revendication 3, dans lequel la courroie sans fin (14) est une courroie d'entraînement dentée développée autour d'une poulie motrice fixe (15) et une poulie de tension ajustable (16).

5. Un copieur à contact conforme à l'une quelconque des revendications 2 à 4, dans laquelle la tête de couvercle (5) est munie d'un roulement à rouleau (18) circulant sur un rail de guidage (19) qui a une portion principale droite (20) s'étendant parallèlement au guide linéaire (12) et une portion d'extrémité en rampe (21) pour diriger la tête de couvercle à la position de stationnement inclinée (A).

6. Un copieur à contact conforme à une quelconque revendication précédente, dans lequel la source d'excitation est une source lumineuse à ultraviolet.
